# EUROPÄISCHE PATENTSCHRIFT

(11) **EP 1 191 539 B1**
(45) Veröffentlichungstag und Bekanntmachung des Hinweises auf die Patenterteilung: **16.03.2005**
(21) Anmeldenummer: 01120856.8
(22) Anmeldetag: 30.08.2001
(51) Int. Cl.: G11C 8/10

(54) **1-aus-N-Decodierschaltung**
1 out of N decoding circuit
Circuit décodeur 1 parmi N

(30) Priorität: 23.09.2000 DE 10047251
(43) Veröffentlichungstag der Anmeldung: 27.03.2002
(73) Patentinhaber: Infineon Technologies AG, 81669 München (DE)
(72) Erfinder: Fischer, Helmut, Dr., 82024 Taufkirchen (DE)
(74) Vertreter: Patentanwaltskanzlei WILHELM & BECK

(56) Entgegenhaltungen:
- EP-A- 0 342 592
- EP-A- 0 365 732
- US-A- 4 731 761
- US-A- 6 020 763
- PATENT ABSTRACTS OF JAPAN vol. 1999, no. 12, 29. Oktober 1999 (1999-10-29) -& JP 11 195294 A (SAMSUNG ELECTRON CO LTD), 21. Juli 1999 (1999-07-21) -& US 6 181 635 B1 (BAE YONG-CHEOL) 30. Januar 2001 (2001-01-30)

## Beschreibung

Die Erfindung betrifft eine Decodierschaltung zum Ansteuern eines ausgewählten Exemplars aus einer Menge von N Ausgangsleitungen abhängig von einer M-Bit-Adresse und in Ansprache auf ein Einschaltsignal, gemäß dem Oberbegriff des Patentanspruchs 1. Derartige 1-aus-N-Decoder sind allgemein bekannt und werden üblicherweise verwendet, um Zeilen- und Spalten-Auswahlleitungen an einer Matrix von Speicherzellen zu adressieren. Hier liegt auch das bevorzugte Anwendungsgebiet der vorliegenden Erfindung.

Wenn die Anzahl N der selektiv anzusteuernden Ausgangsleitungen relativ hoch ist, wie etwa im Falle der Adressierung einer Speichermatrix, dann führt man die 1-aus-N-Decodierung gewöhnlich in Teilschritten durch. Hierbei wird die M-Bit-Adresse in K Segmente aufgeteilt, wobei die Anzahl mₖ der Bits in den einzelnen Segmenten gleich oder unterschiedlich sein kann. Für die K Adressensegmente wird eine Gruppe von K parallelen 1-aus-mₖ-Vordecodern verwendet, deren jeder die Bits eines ihm zugeordneten Segmentes empfängt und für jedes zu erwartende Bitmuster dieses Segmentes genau ein diesem Bitmuster zugeordnetes Exemplar seiner mₖ Ausgänge aktiviert. In der Gesamtmenge aller Vordecoder-Ausgänge ist also immer nur eine Teilmenge aktiviert, die genau K Ausgänge umfasst, jeweils einen von jedem Vordecoder. Es gibt insgesamt N solcher Teilmengen, entsprechend den N möglichen Bitkombinationen, die in der M-Bit-Adresse zur Adressierung der N Ausgangsleitungen zu erwarten sind. Die an den Vordecodern empfangene M-Bit-Adresse bestimmt also, welche der besagten Teilmengen von Vordecoder-Ausgängen aktiviert ist.

Zur weiteren Decodierung der Adresse und zur Ansteuerung der jeweils adressierten Ausgangsleitung ist jede der N erwähnten Teilmengen der Vordecoder-Ausgänge mit K Steuereingängen einer individuell zugeordneten Verknüpfungsschaltung in einem Enddecoder verbunden. Der Enddecoder enthält demnach N solche Verknüpfungsschaltungen, jeweils eine für jede der N Ausgangsleitungen. Bei bekannten Adressendecodern, wie sie z.B. in Verbindung mit Speichermatrizen gebräuchlich sind, besteht jede dieser Verknüpfungsschaltungen aus einem Ansteuerzweig, der K+1 Schalter in Serie enthält. Dieser Ansteuerzweig liegt zwischen der betreffenden Ausgangsleitung und einer Potentialquelle, die das elektrische "Ansteuerpotential" liefert, auf welches die Ausgangsleitungen im angesteuerten Zustand gelegt werden sollen. Die Steueranschlüsse von K Exemplaren dieser Schalter in jedem Ansteuerzweig bilden die mit den K zugeordneten Vordecoder-Ausgängen verbundenen Steuereingänge. Jeder dieser K Schalter ist nur dann durchgeschaltet (d.h. leitend), wenn der mit seinem Steueranschluss verbundene Vordecoder-Ausgang aktiviert ist. Der Steueranschluss des (K+1)-ten Schalters ist zum Empfang des Einschaltsignals angeschlossen; dieser Schalter ist nur während des aktiven Zustandes des Einschaltsignals leitend.

Bei manchen Anwendungen eines mehrschrittigen 1-aus-N-Decodiersystems, das K Vordecoder und einen Enddecoder enthält, steht für jeden der N Ansteuerzweige im Enddecoder nur ein begrenzter Raum zur Verfügung. Dies gilt insbesondere dann, wenn das System als Adressendecoder zum Anwählen von Wortleitungen oder Wortleitungsgruppen oder auch von Bitleitungen einer Speichermatrix eingesetzt wird und auf dem gleichen Chip wie die Matrix integriert ist. Hier ist man aus Layoutgründen meist gezwungen, die einzelnen Ansteuerzweige des Enddecoders z.B. für die Wortleitungen so zu legen, dass ihre Längsausdehnung erstens quer zur Richtung der Wortleitungen verläuft und zweitens nicht größer ist als ein bestimmtes Maß. Dieses Maß hängt davon ab, welchen Abstand die einzelnen Wortleitungen zueinander haben und wieviele Wortleitungen jeder der N Ausgangsleitungen bzw. jedem der Ansteuerzweige des Enddecoders zugeordnet sind. Je dichter die Wortleitungen nebeneinander liegen, desto weniger Raum steht letztlich für die Längsausdehnung eines Ansteuerzweiges zur Verfügung. In diesem Raum muss die Serie der im Ansteuerzweig enthaltenen Schalter Platz finden.

Dieses Raumerfordernis bringt Probleme, insbesondere wenn, wie üblich, die K+1 Schalter in jedem Ansteuerzweig durch Feldeffekttransistoren (FETs) realisiert sind, vorzugsweise durch Transistoren in MOS-Bauweise (MOSFETs), deren Kanäle die Schaltstrecken und deren Gates die Steuerelektroden bilden. Damit ein Feldeffekttransistor zuverlässig sperrt, muss der Kanal zwischen Source und Drain eine gewisse Mindestlänge haben. Dies setzt eine untere Grenze für die Gesamtlänge des Ansteuerzweiges und somit eine untere Grenze für den Abstand der Wortleitungen, was dem Wunsch nach zunehmender Miniaturisierung von Speicherchips entgegensteht.

Es ist daher erstrebenswert, die verwendeten Feldeffekttransistoren so zu optimieren, dass das Verhältnis ihrer Kanallänge zu ihrer Gesamtabmessung möglichst groß ist. Bekanntlich besteht bei der fotolithografischen Herstellung von Feldeffekttransistoren die Tendenz, dass nach Bildung der Source- und Drainzonen die dort implantierten Ladungsträger während folgender Hochtemperatur-Verfahrensschritte in den angrenzenden Bereich der Kanalzone diffundieren und somit die wirksame Länge des Kanals vermindern. Dieser nachteilige Effekt kann beseitigt werden, indem man nach dem Aufbringen des Gateoxids Ladungsträger entgegengesetzten Leitungstyps in die Grenzbereiche zwischen Kanal einerseits und Source bzw. Drain andererseits implantiert. Da diese Grenzbereiche vom Gateoxid überdeckt sind, können sie nur getroffen werden, wenn die Implantierung aus sehr schräger Richtung unter den Seitenrand des Gateoxids erfolgt. Diese Maßnahme ist als "HALO-Implantierung" bekannt und auch gebräuchlich bei der Herstellung der Schalttransistoren für die Ansteuerzweige im Enddecoder von Wortleitungs-Adressierschaltungen.

An einer integrierten Serienschaltung mehrerer Feldeffekttransistoren kann die optimierende HALO-Implantierung nur dann wirksam durchgeführt werden, wenn die Transistoren einen gewissen Mindestabstand haben. Bei sehr enger Anordnung sind nämlich die Lücken zwischen den Gateoxidbereichen benachbarter Transistoren zu schmal, um eine ungehinderte Schrägeinstrahlung des Implantmaterials unter die Seitenränder des Gateoxids zu erlauben. Die erwünschte und an sich vörteilhafte HALO-Implantierung setzt also eine erneute Grenze für die Miniaturisierung.

Die vorstehend beschriebenen Probleme sind nur einige gravierende Beispiele für die Nachteile der bekannten mehrschrittigen 1-aus-N-Decodierschaltungen. Generell besteht die Aufgabe der vorliegenden Erfindung darin, die Decodierschaltung so auszubilden, dass der für die Ansteuerzweige im Enddecoder benötigte Raum vorteilhafter genutzt werden kann als bisher. Insbesondere soll es die Erfindung ermöglichen, den Zwischenraum zwischen den Schaltern in jedem Ansteuerzweig größer zu machen als bisher, ohne den Raum für die Gesamtlänge des Ansteuerzweiges vergrößern zu müssen. Diese Aufgabe wird erfindungsgemäß durch die im Patentanspruch 1 angegebenen Merkmale einer 1-aus-N-Decodierschaltung gelöst.

Demnach enthält eine Decodierschaltung zum Ansteuern eines ausgewählten Exemplars aus einer Menge von N Ausgangsleitungen abhängig von einer M-Bit-Adresse und in Ansprache auf ein Einschaltsignal eine Anzahl K≥2 paralleler Vordecoder, deren jeder ein zugeordnetes Segment der M-Bit-Adresse empfängt und für jedes zu erwartende Bitmuster dieses Segmentes genau ein diesem Bitmuster eindeutig zugeordnetes Exemplar seiner Ausgänge aktiviert. Ein Enddecoder enthält für jede der N Ausgangsleitungen einen gesonderten Ansteuerzweig mit mehreren steuerbaren Schaltern, deren Schaltstrecken in Reihe zwischen der betreffenden Ausgangsleitung und einem Ansteuerpotential liegen. Ein Koppelnetzwerk dient zum Koppeln jeder der N verschiedenen Teilmengen der Vordecoder-Ausgänge, die jeweils genau einen Ausgang jedes der K Vordecoder enthalten, mit den Steueranschlüssen von K Exemplaren der steuerbaren Schalter in einem der betreffenden Teilmenge zugeordneten Exemplar der N Ansteuerzweige, derart dass diese Schalter durchschalten, wenn die mit ihnen gekoppelten Exemplare der Vordecoder-Ausgänge aktiviert sind. Schließlich ist eine Verknüpfungseinrichtung vorgesehen, die ein vollständiges Durchschalten der Ansteuerzweige nur während des Erscheinens des Einschaltsignals erlaubt. Erfindungsgemäß ist die Verknüpfungseinrichtung eine an alle Ausgänge eines der Vordecoder angeschlossene Einrichtung, die auf das Einschaltsignal anspricht, um diese Ausgänge nur während des Erscheinens des Einschaltsignals für die Kopplung mit den Steueranschlüssen der den besagten Ausgängen zugeordneten Schalter in den Ansteuerzweigen freizugeben.

Die Erfindung sieht also vor, die Mittel zum Verknüpfen der Decodierung mit dem Einschaltsignal nicht wie bisher in den Ansteuerzweigen des Enddecoders vorzusehen, sondern diese Mittel in die Vordecoder-Ebene zu verlagern. Der Aufwand hierfür ist gering, weil es genügt, die Ausgänge nur eines der K Vordecoder zu sperren, um jeden der N Ansteuerzweige im Enddecoder am vollständigen Durchschalten zu hindern. Man benötigt also höchstens nur so viele Einzelverknüpfungen mit dem Einschaltsignal, wie Ausgänge am betreffenden Vordecoder vorhanden sind. Diese Anzahl ist höchstens gleich 2^{m}, wenn m die Anzahl der Bits im zugeordneten Segment der Eingangsadresse ist. Beim Stand der Technik, wo die Verknüpfung mit dem Einschaltsignal in den Ansteuerzweigen selbst erfolgte, benötigte man hingegen N=2^{M} Einzelverknüpfungen, wenn M die Anzahl der Bits der Gesamtadresse ist und alle Bitkombinationen der Gesamtadresse als wirksame Adresse genutzt werden (wie zumeist erwünscht und üblich). Dank der Erfindung werden also viele Verknüpfungselemente eingespart, was an sich schon ein Vorteil ist.

Von Vorteil ist aber nicht nur die Zahl eingesparter Verknüpfungselemente sondern insbesondere auch die Orte, wo die Einsparung erfolgt, nämlich die Orte der Ansteuerzweige im Enddecoder. Dank der Erfindung benötigt man in jedem Ansteuerzweig einen Schalter weniger als beim Stand der Technik. Den für jeden Ansteuerzweig verfügbaren Raum auf einem Chip müssen sich also weniger Schalter teilen als bisher. Der Raum kann somit besser für die Kanallänge der als Schalter verwendeten Feldeffekttransistoren und/oder für den Abstand zwischen benachbarten Transistoren ausgenutzt werden. Insbesondere letzteres verbessert die Bedingungen für den Erfolg einer schräggerichteten HALO-Implantierung. Der Miniaturisierungsgrad lässt sich deshalb über das bisher mögliche Maß hinaus steigern.

Besondere Ausführungsformen der Erfindung sind in den Unteransprüchen gekennzeichnet.

Die Erfindung wird nachstehend anhand von Zeichnungen näher erläutert. Es zeigen
- Fig. 1: schematisch den Aufbau einer 1-aus-N-Decodierschaltung nach dem Stand der Technik und
- Fig. 2: das Schema einer gemäß der Erfindung ausgebildeten 1-aus-N-Decodierschaltung.

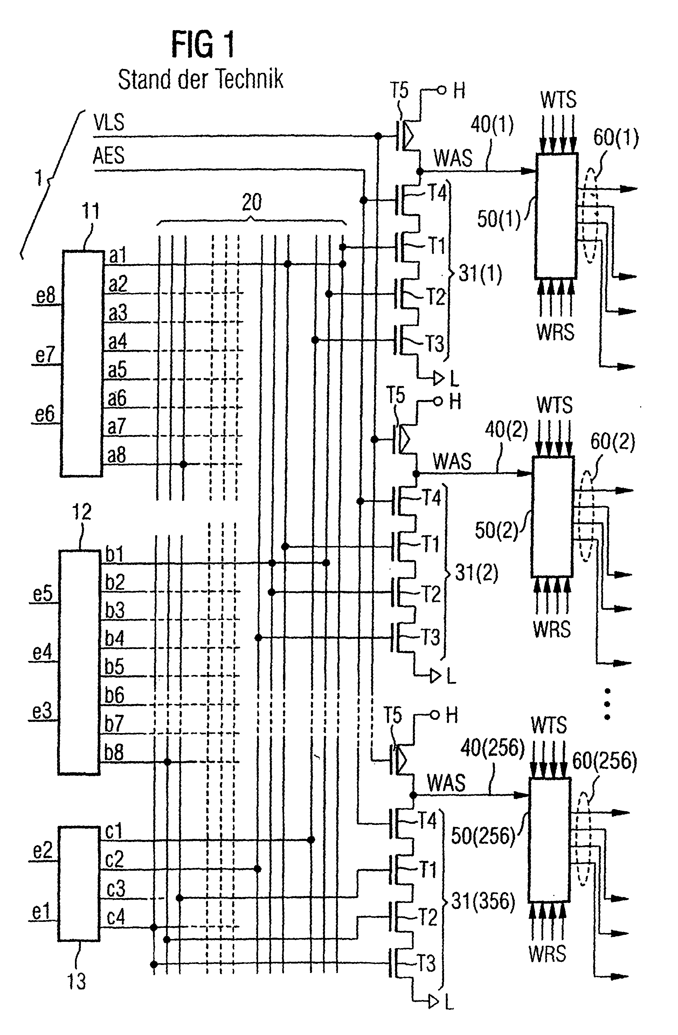

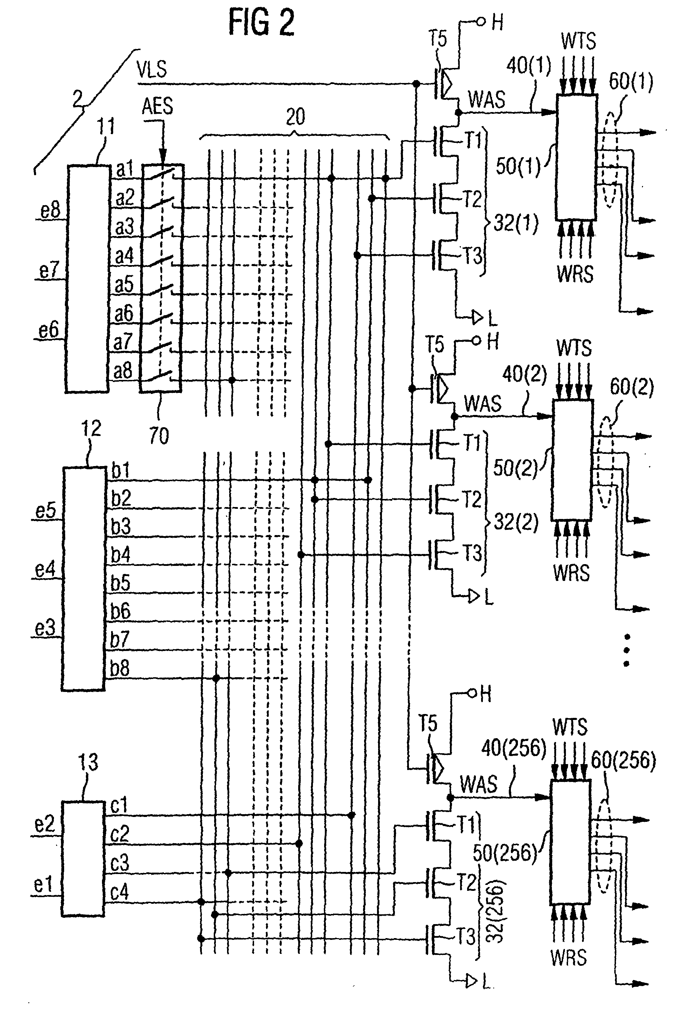

Die in den Figuren 1 und 2 dargestellten Decodierschaltungen 1 bzw. 2 sind Beispiele, die speziell dazu ausgelegt sind, N Wortleitungsgruppen 60 einer Speichermatrix einzeln anzuwählen. Die Wortleitungsgruppen 60 sind disjunkte Teilmengen der Gesamtmenge der Wortleitungen in der Speichermatrix. Im dargestellten Beispielsfall umfasst jede Wortleitungsgruppe 60 vier Wortleitungen, die an vier Ausgänge einer der betreffenden Gruppe individuell zugeordneten Anschlusseinrichtung 50 angeschlossen sind. Jede Anschlusseinrichtung 50 hat einen Eingang zum Empfang eines Wortleitungsgruppen-Auswahlsignals WAS, vier Eingänge für Wortleitungs-Treibersignale WTS und vier Eingänge für Wortleitungs-Rücksetzsignale WRS. Im dargestellten Fall ist eine Wortleitungsgruppe 60 genau dann ausgewählt, wenn das der betreffenden Anschlusseinrichtung 50 angelegte Auswahlsignal WAS niedrigen Pegel (L-Pegel, Binärwert "0") hat. In dieser Situation wird eine Wortleitung dieser Gruppe auf Aktivierungspotential (H-Pegel, Binärwert "1") getrieben, wenn das ihm zugeordnete Exemplar der vier Treibersignale WTS mit H-Pegel erscheint, und auf Deaktivierungspotential (L-Pegel) zurückgesetzt, wenn das ihm zugeordnete Exemplar der vier Rücksetzsignale WRS mit H-Pegel erscheint.

Die Auswahlsignale WAS zur selektiven Ansteuerung der N verschiedenen Anschlusseinrichtungen 50 werden von einer 1-aus-N-Decodierschaltung an Ausgangsleitungen 40 erzeugt, abhängig von einer M-Bit-Adresse, die genügend Bits enthält, um N verschiedene Bitmuster zu liefern. Im folgenden sei zunächst anhand der Fig. 1 eine typische bekannte Ausführungsform einer solchen Decodierschaltung beschrieben.

Das in der Fig. 1 schematisch dargestellte Ausführungsbeispiel einer bekannte Decodierschaltung 1 bildet einen Adressendecoder für N=2⁸=256 Wortleitungs-Vierergruppen 60(1) bis 60(256) einer (nicht gezeigten) Speichermatrix mit insgesamt 1024 Wortleitungen. Die Decodierschaltung 1 hat demnach 256 Ausgangsleitungen 40(1) bis 40(256) von denen nur die ersten beiden Exemplare 40(1), 40(2) und das letzte Exemplar 40(256) dargestellt sind. Jede Ausgangsleitung 40 führt zum WAS-Eingang eines individuell zugeordneten Exemplars der N=256 Anschlusseinrichtungen 50(1) bis 50(256).

Die Decodierschaltung 1 hat M=log₂N=8 Adresseneingänge e1 bis e8 zum Anlegen der 8 Bits einer 8-Bit-Adresse. Die Eingänge e6, e7 und e8 für die drei höchstwertigen Bits (MSBs) der Adresse führen zu einem ersten 1-aus-8-Vordecoder 11, der 8 Ausgänge a1 bis a8 hat und für jede der 4 möglichen Kombinationen seiner beiden Eingangsbits jeweils nur ein einziges, der betreffenden Bitkombination eindeutig zugeordnetes Exemplar dieser Ausgänge aktiviert, indem er diesen Ausgang auf H-Pegel legt.

In ähnlicher Weise führen die Eingänge e3, e4 und e5 für die drei nächst-niedrigeren Bits der Adresse zu einem 1-aus-8-Vordecoder 12, der 8 Ausgänge b1 bis b8 hat und für jede der 8 möglichen Kombinationen seiner drei Eingangsbits jeweils nur ein einziges, der betreffenden Bitkombination eindeutig zugeordnetes Exemplar dieser Ausgänge aktiviert, indem er diesen Ausgang auf H-Pegel legt.

Die Eingänge e1 und e2 für die zwei niedrigstwertigen Bits (LSBs) der Adresse führen zu einem 1-aus-4-Vordecoder 13, der 4 Ausgänge c1 bis c4 hat und für jede der 4 möglichen Kombinationen seiner beiden Eingangsbits jeweils nur ein einziges, der betreffenden Bitkombination eindeutig zugeordnetes Exemplar dieser Ausgänge aktiviert, indem er diesen Ausgang auf H-Pegel legt.

Im Betrieb, beim Anlegen einer beliebigen Adresse an die acht Adresseneingänge e1 bis e8, ist also immer genau ein Ausgang an jedem der Vordecoder 11, 12, 13 auf H-Pegel; die übrigen Ausgänge bleiben auf L-Pegel. Anders ausgedrückt, für jedes Bitmuster an den acht Adresseneingängen sind immer genau drei Vordecoder-Ausgänge aktiviert: einer aus der a-Gruppe a1 bis a8 vom ersten Vordecoder 11, einer aus der b-Gruppe b1 bis b8 vom zweiten Vordecoder 12 und einer aus der c-Gruppe c1 bis c4 vom dritten Vordecoder 13. Es gibt insgesamt 4·8·8=256 solche Dreierkombinationen aktivierter Vordecoder-Ausgänge. Jede dieser Dreierkombinationen ist eine der 256 möglichen Teilmengen, die jeweils genau einen Ausgang jedes der drei Vordecoder enthalten, und wird eindeutig bestimmt durch das Bitmuster der Eingangsadresse.

Über ein Netzwerk 20 aus vielen Leitungen ist jede der vorstehend erwähnten 256 verschiedenen Teilmengen der Vordecoder-Ausgänge mit jeweils einem gesonderten Exemplar von 256 Ansteuerschaltungen verbunden, die ihrerseits an die 256 Ausgangsleitungen 40 der Decodierschaltung 1 angeschlossen sind. Jede Ansteuerschaltung enthält für die betreffende Ausgangsleitung 40 einen Ansteuerzweig 31, der vier in Reihe angeordnete Schalter zwischen einer Quelle für L-Potential und der betreffenden Ausgangsleitung 40 enthält. Im dargestellten Fall sind die vier Schalter durch N-Kanal-Feldeffekttransistoren (N-FETs) T1 bis T4 realisiert. Über einen fünften Feldeffekttransistor T5 mit P-Kanal (P-FET) ist jede Ausgangsleitung 40 mit einer Quelle für H-Potential verbindbar.

Im einzelnen verbindet das Netzwerk 20 den ersten Ausgang a1 des ersten Vordecoders 11 mit der Gateelektrode des ersten N-FET T1 im Ansteuerzweig 31(1) der ersten Ausgangsleitung 40(1), den ersten Ausgang b1 des zweiten Vordecoders 12 mit der Gateelektrode des zweiten N-FET T2 dieses Ansteuerzweiges und den ersten Ausgang c1 des dritten Vordecoders 13 mit der Gateelektrode des dritten N-FET T3 desselben Ansteuerzweiges. Die Gateelektroden der drei N-FETs T1, T2 T3 des Ansteuerzweiges 31(2) der zweiten Ausgangsleitung 40(2) sind mit dem ersten Ausgang a1 des ersten Vordecoders 11, dem ersten Ausgang b1 des zweiten Vordecoders 12 und dem zweiten Ausgang c2 des dritten Vordecoders 13 verbunden. In entsprechend fortgesetzter Permutation sind die jeweils drei N-FETS T1, T2, T3 in den Ansteuerzweigen der übrigen Ausgangsleitungen mit den Ausgängen der drei Vordecoder 11, 12, 13 verbunden, wobei in jedem Ansteuerzweig eine andere der 256 Dreierkombinationen von a- b- und c-Vordecoder-Ausgängen an die Gateelektroden der drei FETs T1, T2, T3 angeschlossen ist. Die Fig. 1 zeigt als Beispiel nur noch den Ansteuerzweig 31(256) der letzten Ausgangsleitung 40(256), deren N-FETs T1, T2, T3 vom jeweils letzten Ausgang a8 bzw. b8 bzw. c4 der drei Vordecoder 11, 12, 13 gesteuert werden.

Dieses Verbindungsschema bewirkt, dass es für jedes Muster von Eingangsadressenbits nur ein diesem Muster eindeutig zugeordnetes Exemplar der Ansteuerzweige 31 gibt, in welchem alle drei N-FETs T1, T2, T3 durch H-Pegel von den Vordecodern 11, 12, 13 durchgeschaltet (leitend) werden. Somit erfolgt eine eindeutige 1-aus-256-Selektion der Ansteuerzweige 31 abhängig von der Eingangsadresse. Allerdings soll die eigentliche Ansteuerung der zugeordneten Ausgangsleitung erst dann erfolgen, wenn ein besonderes Ansteuer-Einschaltsignal AES erscheint. Die entsprechende Verknüpfung besorgt der vierte N-FET T4 in jedem Ansteuerzweig 31, der an seiner Gateelektrode das Ansteuer-Einschaltsignal AES empfängt und nur dann durchschaltet, wenn dieses Signal H-Pegel hat. Erst wenn alle vier N-FETs T1-T4 in einem Ansteuerzweig 31 durchgeschaltet sind, wird der betreffende Ansteuerzweig leitend und verbindet die zugehörige Ausgangsleitung 40 mit dem L-Potential. So wird die Anschlusseinrichtung 50 für die durch die Eingangsadresse bestimmte Wortleitungsgruppe 60 konditioniert, um Wortleitungen der betreffenden Gruppe mittels der ihnen zugeordneten Signale WTS oder WRS aktivieren oder rücksetzen zu können.

Vor dem Wirksamwerden des Signals AES und nach Beendigung dieses Signals werden die P-FETs T5 an den Ausgangsleitungen 40 durch L-Pegel eines Vorladesignals VLS leitend gehalten, um die Ausgangsleitungen 40 auf H-Potential zu halten. Das Signal VLS ist derart zeitgesteuert, dass es spätestens beim Wirksamwerden des Einschaltsignals AES auf H-Pegel geht, um die Ausgangsleitungen 40 vom H-Potential abzukoppeln.

Wie weiter oben erwähnt und in der Zeichnung dargestellt, sind die Ansteuerzweige 31 aus Layoutgründen so anzuordnen, dass sich ihre Längsausdehnung quer zur Richtung der Wortleitungen 60 erstreckt. Die vier Transistoren T1-T4 müssen sich also in ihrer Länge einen begrenzten Raum teilen. Dies bringt die weiter oben ausführlich beschriebenen Integrationsprobleme, die gelöst werden durch erfindungsgemäße Ausbildung der Decodierschaltung, wie es das in Fig. 2 dargestellte Beispiel zeigt.

Viele Teile der erfindungsgemäßen Decodierschaltung 2 nach Fig. 2 entsprechen in Aufbau und Funktion der bekannten Decodierschaltung 1 nach Fig. 1 und sind mit den gleichen Bezugzeichen wie dort bezeichnet. Von einer nochmaligen Beschreibung dieser Teile wird daher abgesehen; näher eingegangen wird im folgenden nur auf die Unterschiede.

Die in Fig. 2 gezeigte Decodierschaltung 2 unterscheidet sich von der bekannten Decodierschaltung 1 darin, dass in jedem ihrer Ansteuerzweige 32 der vierte, auf das Einschaltsignal AES ansprechende N-FET T4 fehlt und stattdessen am ersten Vordecoder 11 eine Einrichtung 70 vorgesehen ist, um die Ausgänge a1 bis a8 dieses Decoders nur beim Erscheinen des Einschaltsignals AES freizugeben. Diese Freigabeeinrichtung 70 ist in der Fig. 2 symbolisch als Gruppe von acht Schaltern dargestellt, die zwischen die acht Ausgänge a1 bis a8 des Vordecoders 11 und die zugehörigen Eingangsleitungen des Koppelnetzwerkes 20 eingefügt sind und sämtlich vom Einschaltsignal AES gesteuert werden, derart, dass sie alle genau dann durchschalten, wenn dieses Signal in wirksamem Zustand (H-Pegel) ist. Somit kann ein aktiver Zustand (H-Pegel) irgendeines der Ausgänge des Vordecoders 11 nicht weitergeleitet werden, solange das Einschaltsignal AES ausbleibt.

Weil die N-FETs T1 in allen Ansteuerzweigen 32 von den Ausgängen des ersten Vordecoders 11 gesteuert werden und nur dann durchschalten, wenn sie H-Pegel von irgendeinem dieser Ausgänge empfangen, bleiben auch sie solange gesperrt, wie das Einschaltsignal AES ausbleibt. Erst wenn das Signal AES wirksamen Zustand hat, kann die von einem aktiven Ausgang des Vordecoders 11 ausgewählte Menge der N-FETs T1 durchschalten. In der Decodierschaltung 2 nach Fig. 2 erfüllen die N-FETs T1 somit eine Doppelfunktion: erstens die Teilauswahl der Ansteuerzweige 32 abhängig von der 1-aus-8-Decodierung des Vordecoders 11 (ebenso wie in der bekannten Decodierschaltung 1 nach Fig. 1) und zweitens die Verknüpfung des Ansteuerbetriebs mit dem Ansteuer-Einschaltsignal AES (die in der bekannten Decodierschaltung mittels des dort vorhandenen vierten N-FET T4 erfolgte).

Die besagte Doppelfunktion der N-FETs T1 erlaubt also den Wegfall des N-FETs T4, so dass in jedem Ansteuerzweig 32 der erfindungsgemäßen Decodierschaltung 2 ein N-FET weniger integriert werden muss als im bekannten Fall. Hierdurch hat jeder der N-FETs in den Ansteuerzweigen 32 mehr Platz, so dass die N-FETs in jedem Ansteuerzweig mit größerer Kanallänge und/oder mit größerem gegenseitigem Abstand versehen werden können, wie es deutlich in der Fig. 2 zu erkennen ist. Somit ist es auch möglich, bei sehr eng gepackten Wortleitungen einer Speichermatrix die N-FETs in den querliegenden Ansteuerzweigen des Enddecoders mit genügend großer Kanallänge und/oder mit HALO-Implantaten zur Optimierung ihres Sperrwiderstandes zu versehen.

Die vorstehend anhand der Fig. 2 beschriebene Decodierschaltung 2 ist nur ein Ausführungsbeispiel, auf welches die vorliegende Erfindung nicht beschränkt ist. Dies gilt sowohl hinsichtlich des Typs der beschriebenen Transistoren als auch hinsichtlich der Auswahl der steuernden Signalpegel. Natürlich kann auch die Anzahl der Wortleitungen pro Wortleitungsgruppe 60, also die Mächtigkeit der auszuwählenden Teilmengen, anders als vier sein; jede Zahl ≥1 ist möglich. Der für die Längsausdehnung der Ansteuerzweige 32 zur Verfügung stehende Raum wird umso kleiner, je größer die Packungsdichte der Wortleitungen und je kleiner die Mächtigkeit der Wortleitungs-Teilmengen 60 ist, die von jeweils einer Anschlusseinrichtung 50 bedient werden. Ist der besagte Raum sehr eng begrenzt, kann es erforderlich sein, jeweils zwei oder mehr Exemplare der N Ansteuerzweige auf dem Chip übereinander zu "stapeln". Auch bei dieser Variante ist die Erfindung mit Vorteil anwendbar.

Das erfindungsgemäße Prinzip, die Verknüpfung mit dem Ansteuer-Einschaltsignal an einem der Vordecoder anstatt im Enddecoder vorzunehmen, kann bei jeder Art von mehrschrittigen 1-aus-N-Decodierschaltungen vorteilhaft sein, allein schon wegen der geringeren Anzahl notwendiger Einzelverknüpfungen. Somit ist die Erfindung auch nicht beschränkt auf die beschriebene Verwendung zur Adressierung von Auswahlleitungen für Speicherzugriff, ebensowenig ist sie beschränkt auf die Verwendung von Ansteuerzweigen, in denen Feldeffekttransistoren als Schalter dienen.

Zusammenfassend und allgemein gesagt ist der Gegenstand der Erfindung eine 1-aus-N-Decodierschaltung, die zum Ansteuern eines ausgewählten Exemplars aus einer Menge von N Ausgangsleitungen abhängig von einer M-Bit-Adresse und in Ansprache auf ein Einschaltsignal folgendes enthält: eine Anzahl K≥2 paralleler Vordecoder, deren jeder ein zugeordnetes Segment der M-Bit-Adresse durch Aktivierung genau eines Exemplars seiner Ausgänge decodiert; einen Enddecoder, der für jede der N Ausgangsleitungen einen gesonderten Ansteuerzweig mit einer Gruppe aus K steuerbaren Schaltern in Reihe zwischen der betreffenden Ausgangsleitung und einem Ansteuerpotential aufweist, wobei jede Schaltergruppe im Enddecoder von genau einer zugeordneten Teilmenge der Vordecoder-Ausgänge, die genau einen Ausgang von jedem Vordecoder enthält, durchschaltbar ist; eine an die Ausgänge eines der Vordecoder angeschlossene Einrichtung, die auf das Einschaltsignal anspricht, um diese Ausgänge nur während des Erscheinens des Einschaltsignals für die Kopplung mit den zugeordneten Schaltern in den Ansteuerzweigen freizugeben.

## Patentansprüche

1. Decodierschaltung (2) zum Ansteuern eines ausgewählten Exemplars aus einer Menge von N Ausgangsleitungen (40) abhängig von einer M-Bit-Adresse (e1,..., e8) und in Ansprache auf ein Einschaltsignal (AES), mit folgenden Einrichtungen:
einer Anzahl K≥2 paralleler Vordecoder (11, 12, 13); deren jeder ein zugeordnetes Segment der M-Bit-Adresse empfängt und für jedes zu erwartende Bitmuster dieses Segmentes genau ein diesem Bitmuster eindeutig zugeordnetes Exemplar seiner Ausgänge (a1-a8 bzw. b1-b8 bzw. c1-c4) aktiviert;
einem Enddecoder, der für jede der N Ausgangsleitungen (40) einen gesonderten Ansteuerzweig (32) mit mehreren steuerbaren Schaltern (T1-T3) enthält, deren Schaltstrecken in Reihe zwischen der betreffenden Ausgangsleitung (40) und einem Ansteuerpotential (L) liegen;
einem Koppelnetzwerk (20) zum Koppeln jeder der N verschiedenen Teilmengen der Vordecoder-Ausgänge (a1-a8, b1-b8, c1-c4), die jeweils genau einen Ausgang jedes der K Vordecoder (11, 12, 13) enthalten, mit den Steueranschlüssen von K Exemplaren der steuerbaren Schalter (T1, T2, T3) in einem der betreffenden Teilmenge zugeordneten Exemplar der N Ansteuerzweige (32), derart dass diese Schalter (T1, T2, T3) durchschalten, wenn die mit ihnen gekoppelten Exemplare der Vordecoder-Ausgänge aktiviert sind,
und einer Verknüpfungseinrichtung (70), die ein vollständiges Durchschalten der Ansteuerzweige (32) nur während des Erscheinens des Einschaltsignals (AES) erlaubt,
**dadurch gekennzeichnet,**
**dass** die Verknüpfungseinrichtung (70) eine an alle Ausgänge (a1-a8) eines der Vordecoder (11) angeschlossene Einrichtung (70) ist, die auf das Einschaltsignal (AES) anspricht, um diese Ausgänge (a1-a8) nur während des Erscheinens des Einschaltsignals (AES) für die Kopplung mit den Steueranschlüssen der den besagten Ausgängen (a1-a8) zugeordneten Schalter (T1, T2, T3) in den Ansteuerzweigen (32) freizugeben.

2. Decodierschaltung nach Anspruch 1, **dadurch gekennzeichnet, dass** sie als Adressendecoder für die Adressierung von N Teilmengen (60) von parallel zueinander verlaufenden Auswahlleitungen einer Speichermatrix auf dem gleichen Halbleiterchip wie die Speichermatrix integriert ist,
wobei jede der Ausgangsleitungen (40) mit einer Anschlusseinrichtung (50) für eine zugeordnete Teilmenge (60) der Auswahlleitungen (60) verbunden ist
und wobei die Reihenschaltung der Schalter (T1-T3) in jedem Ansteuerzweig (32) ihrer Länge nach quer zur Richtung des Verlaufs der besagten Auswahlleitungen der Speichermatrix angeordnet ist.

3. Decodierschaltung nach Anspruch 2, **dadurch gekennzeichnet, dass** die Schalter (T1-T3) in jedem Ansteuerzweig (32) Feldeffekttransistoren sind, deren Kanäle die Schaltstrecken und deren Gateelektroden die Steueranschlüsse bilden.

4. Decodierschaltung nach Anspruch 3, **dadurch gekennzeichnet, dass** die Feldeffekttransistoren (T1-T3), welche die Schalter in den Ansteuerzweigen (32) bilden, durch HALO-Implantate an den Enden ihrer Kanäle optimiert sind.

5. Decodierschaltung nach einem der Ansprüche 2 bis 4, **dadurch gekennzeichnet, dass** jede der Ausgangsleitungen (40) mit der Anschlusseinrichtung (50) für eine zugeordnetes Teilmenge (60) der Wortleitungen (60) der Speichermatrix verbunden ist.

## Claims

1. Decoder circuit (2) for driving a selected instance from a set of N output lines (40) on the basis of an M-bit address (e1,..., e8) and in response to a turn-on signal (AES), having the following devices:
a number K≥2 of parallel input decoders (11, 12, 13), each of which receives an associated segment of the M-bit address and, for each bit pattern to be expected for this segment, activates precisely one instance of its outputs (a1-a8 or b1-b8 or c1-c4) which is uniquely associated with this bit pattern;
an output decoder which contains, for each of the N output lines (40), a separate drive path (32) having a plurality of controllable switches (t1-t3) whose switching paths are arranged in series between the output line (40) in question and a drive potential (L);
a switching network (20) for coupling each of the N different subsets of the input decoder outputs (a1-a8, b1-b8, c1-c4), which respectively contain one output of each of the K input decoders (11, 12, 13), to the control connections of K instances of the controllable switches (T1, T2, T3) in one instance of the N drive paths (32) which is associated with the subset in question, such that these switches (T1, T2, T3) turn on when those instances of the input decoder outputs which are coupled to them have been activated,
and a combinational logic device (70) which permits the drive paths (32) to be connected fully only during the appearance of the turn-on signal (AES),
**characterized**
**in that** the combinational logic device (70) is a device (70) which is connected to all the outputs (a1-a8) of one of the input decoders (11) and responds to the turn-on signal (AES) in order to enable these outputs (a1-a8) for coupling to the control connections of the switches (T1, T2, T3) associated with said outputs (a1-a8) in the drive paths (32) only during the appearance of the turn-on signal (AES).

2. Decoder circuit according to Claim 1, **characterized in that** it is integrated, in the form of an address decoder for addressing N subsets (60) of selection lines running parallel to one another in a memory matrix, on the same semiconductor chip as the memory matrix,
each of the output lines (40) being connected to a connection device (50) for an associated subset (60) of the selection lines (60),
and the series circuit which comprises the switches (T1-T3) being arranged, according to its length, in each drive path (32) transversely with respect to the direction in which said selection lines run in the memory matrix.

3. Decoder circuit according to Claim 2, **characterized in that** the switches (T1-T3) in each drive path (32) are field effect transistors whose channels form the switching paths and whose gate electrodes form the control connections.

4. Decoder circuit according to Claim 3, **characterized in that** the field effect transistors (T1-T3) forming the switches in the drive paths (32) are optimized by HALO implants at the ends of their channels.

5. Decoder circuit according to one of Claims 2 to 4, **characterized in that** each of the output lines (40) is connected to the connection device (50) for an associated subset (60) of the word lines (60) in the memory matrix.

## Revendications

1. Circuit décodeur (2) servant à commander une ligne de sortie (40) sélectionnée, en fonction d'une adresse à M bits (e1, ..., e8) et en réponse à un signal de commutation (AES), parmi un ensemble de N lignes de sortie, lequel circuit comprend les dispositifs suivants :
un nombre K ≥ 2 de prédécodeurs parallèles (11, 12, 13) dont chacun reçoit un segment associé de l'adresse à M bits et, pour chaque configuration binaire attendue de ce segment, active exactement un exemplaire de ses sorties (a1 à a8 ou b1 à b8 ou c1 à c4) associé de manière univoque à cette configuration binaire ;
un décodeur final qui, pour chacune des N lignes de sortie (40), contient une branche de commande (32) distincte comprenant plusieurs commutateurs (T1 à T3) pouvant être commandés dont les sections logiques sont montées en série entre la ligne de sortie (40) concernée et un potentiel de commande (L) ;
un réseau de couplage (20) servant à coupler chacun des N différents sous-ensembles de sorties de prédécodeur (a1 à a8, b1 à b8, c1 à c4), qui contiennent chacun exactement une sortie de chacun des K prédécodeurs (11, 12, 13), aux raccords de commande d'un nombre K de commutateurs pouvant être commandés (T1, T2, T3) situés dans un exemplaire des N branches de commande (32) associé au sous-ensemble concerné, de telle sorte que ces commutateurs (T1, T2, T3) soient mis en communication lorsque les sorties de prédécodeur couplées avec eux sont activées,
et un dispositif de connexion (70) qui ne permet une mise en communication complète des branches de commande (32) que pendant la présence du signal de commutation (AES),
**caractérisé en ce que** le dispositif de connexion (70) est un dispositif (70) qui est raccordé à toutes les sorties (a1 à a8) d'un des prédécodeurs (11) et qui répond au signal de commutation (AES) pour n'autoriser le couplage de ces sorties (a1 à a8) aux raccords de commande des commutateurs (T1, T2, T3) associés auxdites sorties (a1 à a8) et situés dans les branches de commande (32) que pendant la présence du signal de commutation (AES).

2. Circuit décodeur selon la revendication 1, **caractérisé en ce que** celui-ci est intégré, en tant que décodeur d'adresses servant à l'adressage de N sous-ensembles (60) de lignes de sélection d'une matrice mémoire s'étendant parallèlement entre elles, sur la même puce semi-conductrice que la matrice mémoire,
chacune des lignes de sortie (40) étant reliée à un dispositif de raccordement (50) pour un sous-ensemble associé (60) de lignes de sélection (60)
et le couplage en série des commutateurs (T1 à T3) étant disposé dans chaque branche de commande (32), en fonction de sa longueur, transversalement à la direction du cours desdites lignes de sélection de la matrice mémoire.

3. Circuit décodeur selon la revendication 2, **caractérisé en ce que** les commutateurs (T1 à T3) situés dans chaque branche de commande (32) sont des transistors à effet de champ dont les canaux forment les sections logiques et dont les électrodes de grille forment les raccords de commande.

4. Circuit décodeur selon la revendication 3, **caractérisé en ce que** les transistors à effet de champ (T1 à T3) qui forment les commutateurs situés dans les branches de commande (32) sont optimisés grâce à des implants HALO placés aux extrémités de leurs canaux.

5. Circuit décodeur selon l'une des revendications 2 à 4, **caractérisé en ce que** chacune des lignes de sortie (40) est reliée au dispositif de raccordement (50) pour un sous-ensemble associé (60) de lignes de mots (60) de la matrice mémoire.
